Europäisches Patentamt

European Patent Office

Office européen des brevets

(11) Publication number: **0 197 422 B1**

# EUROPEAN PATENT SPECIFICATION

(45) Date of publication of patent specification: **27.05.92**

(51) Int. Cl.5: **H01L 21/76,** H01L 21/312, H01L 21/316

(21) Application number: **86104052.5**

(22) Date of filing: **25.03.86**

(54) Resin glass filled deep trench isolation.

(30) Priority: **04.04.85 US 719848**

(43) Date of publication of application:
**15.10.86 Bulletin 86/42**

(45) Publication of the grant of the patent:
**27.05.92 Bulletin 92/22**

(84) Designated Contracting States:
**DE FR GB IT**

(56) References cited:
**EP-A- 0 025 129**

**IBM TECHNICAL DISCLOSURE BULLETIN, vol. 22, no. 5, October 1979, pages 1862-1863, New York, US; P.J. BURKHARDT et al.: "Process for providing deep trench silicon isolation"**

**IBM TECHNICAL DISCLOSURE BULLETIN, vol. 21, no. 4, September 1978, pages 1466-1467, New York, US; J.S. LOGAN et al.: "Method of etching/filling deep trench isolation for large-scale integrated devices"**

(73) Proprietor: **International Business Machines Corporation**
**Old Orchard Road**
**Armonk, N.Y. 10504(US)**

(72) Inventor: **Chiu, George Tein-Chu**
**48 Brandy Lane**
**Wappingers Falls New York 12590(US)**
Inventor: **Mo, Roy Ah-Tak**
**138-10 Franklin Avenue Apt. 14N**
**Flushing New York 11355(US)**
Inventor: **Wong, Man-Chong**
**16 Jackson Drive**
**Poughkeepsie New York, 12603(US)**

(74) Representative: **Mönig, Anton, Dipl.-Ing.**
**IBM Deutschland GmbH Patentwesen und Urheberrecht Schönaicher Strasse 220**
**W-7030 Böblingen(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

This invention relates to a method of as described in the first part of claim 1 forming deep dielectric filled isolation trenches in the surface of a semiconductor substrate.

Recessed dielectric isolation and in particular, recessed silicon dioxide isolation are known in large scale integrated semiconductor devices for providing electrically isolated pockets on the same silicon chip. Such are used typically for separating the base and collector contact regions of transistors constructed with isolated pockets and additionally, for insulating conductors from the underlying silicon substrate. In the context of large scale integrated circuits, a requirement exists for a large number of surface conductors for the distribution of operating voltages and currents and digital signals from device to device. While such surface conductors are insulated from the semiconductor substrate upon which they lie, there is, to a certain degree, a capacitive coupling present between the insulated conductors and the substrate through the intervening material. Such a capacitive coupling degrades the signals carried by the surface conductors. This capacitive coupling may be minimized by increasing the thickness of the dielectric material separating the conductors from the substrate. However, to maintain the planarity of such surface conductors, it is preferable to recess the dielectric material beneath the material of the substrate rather than adding dielectric material above the surface of the substrate.

Within the technology, it is known that dielectric isolation can be produced by first selectively removing silicon from the substrate and then filling the trenches with a dielectric material. Such is disclosed in U.S. Patent US-A-3,966,577.

To minimize the silicon chip area occupied by dielectrically filled trenches, various techniques are utilized to form trenches in the silicon substrate. Typical are sputter etching processes and reactive ion etching processes.

U.S. Patent US-A-4,104,086 is directed to a technique of achieving well-filled deep narrow grooves with near vertical walls by employing reactive ion etching (R.I.E.). That technique employs the formation of slightly tapered narrow grooves cut through buried, highly doped Si regions, thermal oxidation of the grooves and proper filing-in of the remaining grooves with a vapor deposited dielectric material. This patent emphasizes the need for forming slightly tapered walls and then addresses the dependency and quality, as well as planarity of the dielectric filling material on the groove taper angle and groove width. The patent also employs back etching of the filling material which covers the total wafer with R.I.E. to remove material everywhere from the surface and leave only isolation pockets. Another technique of trench forming using R.I.E. is also disclosed in U.S. Patent US-A-4,139,442. In that patent, narrowed deep recessed oxide regions are formed in the silicon substrate by R.I.E. to form narrow trenches followed by thermally oxidizing the trench walls to completely fill the trenches.

The art is replete with a variety of other techniques to provide dielectric isolation in integrated circuit structures. Prior art representative of those techniques will be discussed and other art will simply be summarized.

U.S. Patent US-A-3,442,011 discloses selective inversion of portions of a semiconductor wafer from a semiconducting to an insulating status. This provides unconverted "pockets" of single-crystal semiconducting material isolated from each other by the insulating portions. Such conversion is achieved by masking the portions of the semiconductor wafer which are to remain semiconducting and thereafter chemically etching the unmasked portions with oxygen to form a new species of material which is insulating. In this example of oxygen, the new species would be silicon oxide. The pockets of unconverted semiconductor material serve as regions into which subsequent diffusions may be made or epitaxial depositions carried out in order to form diode or transistor structures of an integrated circuit. These may be joined by a common substrate but are electrically isolated through the substrate through the insulating portions.

U.S. Patent US-A-3,648,125 discloses a thin silicon epitaxial layer formed on a silicon substrate which is subdivided into electrically isolated pockets by a grid of oxidized regions of epitaxial silicon material which extend through the eptaxial layer to a laterally extending P-N junction.

U.S. Patent US-A-3,698,966 relates to oxide films in a nitride layer which are selectively formed over the surface of a semiconductor wafer to define areas of the wafer in which field effect devices may be formed. The nitride layer masks the inner oxide film as an oxide layer is formed around the masked regions to form laterally isolated semiconductor islands in which the field effect devices are formed. A portion of the nitride layer is employed to mask the oxide film defining the gate region of the field effect device. Conductivity regions are formed in the island by diffusion as nitride layers mask contact regions of the field effect devices. Contacts are then conventionally formed.

U.S. Patent US-A-3,796,613 discloses dielectrically isolated pedestal semiconductor devices which are particularly adaptable to form a portion of an integrated circuit. The structure disclosed in this patent can be employed for integrated circuits including FET and/or bipolar transistors. A significant savings in surface area and a reduction in capacitance can be obtained over prior techniques using the method of this patent. This method involves forming a layer of dielectric material on a semiconductor body having a diffused region where a bipolar device is to be formed and then forming an opening in the layer to expose a portion of the surface of the diffused region of the semiconductor body. An epitaxial layer of silicon is deposited on top and single crystal silicon will then grow over the exposed silicon area if a disposed region is present in the substrate such that a pedestal will out-diffuse through the same area from the buried diffused region. Polycrystalline silicon will grow on top of the dielectric material. The pedestal is formed in a single crystal epitaxial layer of a different impurity type. Two other active elements of a bipolar transistor, such as the emitter and intrinsic base regions, are then formed in the same single crystal epitaxial layer while the inactive area, such as the intrinsic base, is formed in polycrystalline silicon. A reachthrough is made through the dielectric layer to the third element of the transistor, that is the collector region.

U.S. Patent US-A-3,873,383 discloses a method of making a semiconductor device in a surface of a semiconductor body having an inset pattern of insulating material in which an additional doped zone is provided adjacent to the inset pattern. Prior to the provision of the inset pattern, providing an oxidation and impurity masking layer with apertures at the areas were the inset pattern is to be formed, the body is doped through the apertures. Thereafter, body portions are oxidized through the apertures to provide oxidation junction isolation and channel stop.

U.S. Patent US-A-3,886,000 discloses a dielectric isolation barrier formed in a silicon substrate by oxidizing openings formed in an epitaxial layer on the substrate and a layer of silicon oxynitride which is on the surface of the epitaxial layer of the substrate. During this oxidation of the openings, the layer of silicon oxynitride is thermally oxidized to form an electrically insulating layer of silicon dioxide on the surface of the epitaxial layer which is homogeneous with the silicon dioxide of the dielectric isolation barrier. The index of refraction of the layer of silicon oxynitride is selected in accordance with its thickness to produce a desired thickness of the layer of silicon dioxide after completion of oxidation of the openings in which the dielectric isolation barrier is formed. The patent describes the index of refraction of this material as preferably between 1.55 and 1.70.

U.S. Patent US-A-3,894,893 relates to a technique for the production of semiconductor devices composed of a plurality of polycrystalline regions and monocrystalline regions epitaxially grown on the substrate such that between each of the two types of regions, at least one monocrystalline to polycrystalline junction is formed. By this technique, the conventional diffusion-type isolation process, difficult to practice, is eliminated.

Reference is made to U.S. Patents US-A-3,832,202; US-A-3,834,939; US-A-3,892,608; US-A-3,900,350; US-A-3,935,328; US-A-4,075,044; US-A-4,132,586; US-A-4,374,011; Japanese Laid Open Application JP-A-57-303,336, February 18, 1982; Japanese Laid Open Application JP-A-55-138,262, April 13, 1979; and Japanese Laid Open Application JP-A-56-146,251, April 14, 1980; IBM TDB, Vol. 13, No. 5, p. 1297, October 1970; and IBM TDB, Vol. 22, No. 4, p. 1542, September 1979; and for other techniques of general interest.

More pertinent is that disclosed in U.S. Patent US-A-3,998,673 which relates to a process of forming electrically isolated regions in integrated circuits in the formation of dielectric moats surrounding the regions and P-N junctions underlying those regions. Moats or notches are etched into the substrate prior to the formation of a buried isolation layer, or further dielectric materials such as silicon dioxide is deposited in the notches or moats, and polycrystalline silicon is thereafter grown on the surface of the wafer to fill the notches or moats. The excess polysilicon formed on the surface of the wafer is then removed by mechanical lapping or polishing. Since there has been no doping or epitaxial growth, the wafer may be lapped directly on the substrate to remove all polycrystalline and oxide from the surface while leaving the notches or moats lined with dielectric material filled with polysilicon.

U.S. Patent US-A-4,001,465 employs a ring or lattice-shaped groove trench etched into the surface of a Si monocrystal. At least one boundary of the so-called etched groove is coated with a strip-layer of an oxide blocking material such as $Si_3N_4$ and the area over the substrate adjacent to the $Si_3N_4$ layer and/or over the substrate area enclosed by such layer is provided with a relatively thick $SiO_2$ layer which extends deeper than the Si surface than does the $SiN_4$ layer while the surface within the groove or trench remains uncoated. This arrangement is then thermally oxidized under conditions sufficient to at least partially fill the groove or trench with $SiO_2$. Thereafter, the oxidation blocking layer and at least a part of the $SiO_2$ layer which is outside the ring or lattice-shape trench is removed by a suitable echant from the monocrystalline surface and the thus uncovered Si surface is further processed to produce small P-N junctions.

An example of a prior art technique of filling a dielectrically filled isolation trench by means of an organic plug material is disclosed in U.S. Patent US-A-4,222,792. The organic material is resin glass. As used herein, the term "resin glass" is defined as a polymer consisting of alternating atoms of silicon and oxygen with organic groups attached to the silicon atoms. The types of groups in a mount of organic substitutions determine whether the resin is a liquid or a solid and also determines the nature of the cured resin. Heat treatment enables a film of this polymer to be converted to silica by eliminating the organic residues. Reference is made to U.S. Patents 3,985,597 and 4,004,044 or other patents employing "resin glass". Said US-A-4.222.792 utilizes a number of known resin glasses, such as Dow-Corning '805, Owens - Illinois '650, and General Electric SR '124 and '125. In this patent, a wide trench is formed in the surface of a silicon substrate and a layer of organic resin glass and a solvent is spin-coated over the surface of the semiconductor substrate and within the trench. The resin glass which exists in the trench is exposed to an electron beam to render the resin glass impervious to a developing solvent. The remainder of the resin glass is stripped away by developing in a solvent, and a resin glass plug within the trench is converted to silicon dioxide by heating in an oxygen environment. Then, a layer of silicon dioxide is deposited over the entire surface of the semiconductor substrate and etched away to planarize the trench.

This technique, while generally satisfactory, has several problems. First, the resin glass used to form the glass plug is impure and adds contaminants to the semiconductor substrate through diffusion and migration. Given this problem, said US-A-4 222.792 adds a contaminant barrier layer, that is, a chemical vapor deposited silicon nitride layer added prior to trench filling and then removed from the surface of the substrate after the trench has been filled. This complicates the process. Traditionally, it is difficult to provide trenches of different widths since the liquid resin glass remains planar over a narrow trench but tends to follow the contours of a wide trench. When the resin glass and the narrow and wide trenches are electron beam exposed, the unexposed resin glass is stripped away and a mound of resin glass will remain over the narrow trench above the surface of the semiconductor substrate. This mound of resin glass must be removed to planarize the narrow trench.

Resin glass, however, remains attractive especially in techniques such as the PIT process which have employed polyamide materials having themselves a problem of outgassing. This problem tends to cause black metal and cracks in the quartz passivation layer. Consequently, to fill the trenches with polyamide, alternative techniques which eliminate this problem have been explored. The prior art heretofore has not provided an entirely acceptable method of forming dielectrically filled isolation trenches in the surface of a silicon semiconductor substrate for the reasons noted herein.

The invention as claimed provides a solution to the afore-mentioned problems associated with a planar deep oxide isolation process. Preferably the process has to provide for trenches in the surface of a silicon semiconductor substrate with the requirements that the trench filling dielectric materials will not outgas during subsequent device processing. Moreover, the process for forming deep oxide isolation should be independent of the size of the trench.

The method according to the invention is disclosed in Claim 1. The dependent claims show particular embodiments of the invention.

The dielectric is a resin glass and planarization comprises coating the dielectric with a blanket photoresist layer such as AX 1350J made by Shipley Corp., Newton, Massachusetts and the RIE the resist and the resin glass until the magnesium oxide layer is exposed on the substrate top surface. Additional steps may be performed to remove the magnesium oxide layer from the substrate top surface.

This invention will be described in greater detail by referring to the attached drawings and the description of the preferred embodiment which follows.

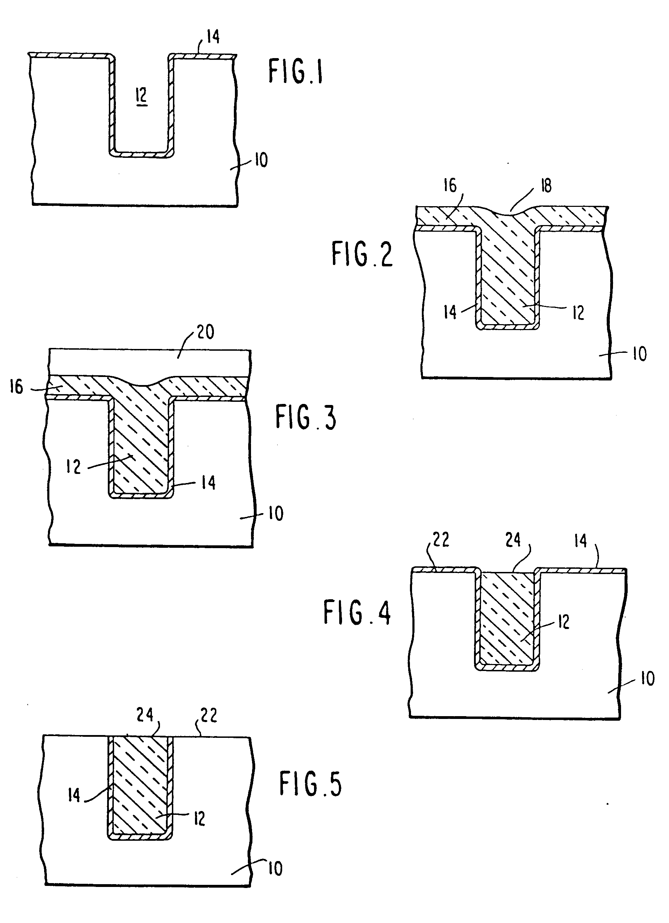

Figures 1-5 are respectively simplified cross views of a portion of a semiconductor structure at successive stages of the planar deep oxide isolation process performed in accordance with this invention.

Referring now to Figures 1-5, the method in accordance with this invention will be described. As illustrated in Figure 1, trenches of sufficient deep and width typically between 2-5 $\mu$m in depth and width, according to design parameters, are first formed in a semiconductor substrate 10. The trenches themselves may be formed by any of the common techniques employed in the industry, and the trenches may have the CVD oxide-nitride barrier layer. A thin layer 14 of magnesium oxide (MgO) is then deposited on the wafer to cover the substrate surface and the trench walls. MgO is employed in this method for RIE etchback. That is, the MgO layer is used as an etchstop layer in subsequent device processing.

The second step is illustrated in Figure 2. A layer of resin glass is applied to the device. The resin glass may be applied by various techniques, such as spin techniques disclosed herein such that the resin glass layer 16 completely fills the trenches and covers the MgO layer 14. As illustrated in Figure 2, the resin glass layer may have a slight recess 18 which is a function of the width of the trench 12. However, in accordance with the process disclosed herein, the existence of the recess 18 is not critical. The resin glass is cured to an appropriate temperature such as baking at a high temperature equal to or greater than 400ºC. Depending on the trench size and the thickness required, a double coating of resin glass may be required.

The resin glass used in accordance with this invention is a polymer as defined herein. The polymer, methyl othoxy polysiloxane, however, has a main chain which is basically inorganic (Si-O-Si). The side groups may, however, be organic. This hybrid material, therefore, has important properties of both organic and inorganic structures. Because it is a polymer, it is easy to fill up the trenches in a manner set forth in Figure 2. The curing and baking of this material at high temperatures in excess of 400ºC tends to polymerize the organic specie and eventually leave a merely inorganic material $SiO_x$ which does not have any outgassing problem associated with it. Consequently, in the PIT process, resin glass is preferred to a polyamide since it does not have an outgassing problem associated with it, nor does it tend to cause cracks in the quartz passivation layer.

Figure 3 illustrates the third step in this method. On top of the resin glass layer 16, a suitable photoresist is deposited. The photoresist is required for the RIE planarization etchback process. This is illustrated in Figure 4. The reactive ion etching (RIE) takes place such that etchback for planarization occurs until the resin glass level on the silicon surface is reduced to a point substantially coplanar with the top surface 22 of the silicon substrate. As illustrated in Figure 4, the magnesium oxide layer 14 still exists such that the resin glass now fills the trench 12 but has been planarized by RIE to have a top surface 24 substantially coplanar with the surface 22 of the semiconductor substrate.

The last step is the removal of the MgO layer from surface 22 of the semiconductor device. That is, following etchback, the MgO layer is chemically removed with acid, such as oxalic acid or Chromic/Nitric acid.

## Claims

1. A method for dielectrically isolating segments of a semiconductor substrate, comprising:

a semiconductor substrate (10) having trenches (12) defining said segments in isolation from each other;

characterised in that:

the top surfaces of said substrate are coated with magnesium oxide layer (14) inclusive of the side and bottom walls of said trenches (12);

concurrently said trenches are filled and said substrate is coated with a dielectric (16); and

said dielectric is planarised to a level exposing and coextending with the magnesium oxide layer on the substrate's top surface.

2. The method of Claim 1 wherein said substrate segments comprise an integrated circuit structure.

3. The method of Claims 1 or 2 wherein said dielectric (16) is a resin glass.

4. The method of one of the preceding Claims wherein said planarization comprises coating said dielectric (16) with a blanket resist layer (20), and reactive ion etching said resist and said resin glass until said magnesium oxide layer (14) is exposed on said top surface of said substrate (10).

5. The method of one of the preceding Claims further including the step of removing said magnesium oxide layer from said top surface of the substrate.

6. The method of one of the preceding Claims wherein the step of concurrently filling said trenches and coating said substrate comprises diluting said dielectric and spin applying said diluted dielectric to said substrate.

7. The method of Claim 6 further comprising the step of curing said dielectric by heating to a temperature equal to or in excess of 400ºC.

8. The method of Claim 5 wherein said step of removing said magnesium oxide layer (14) comprises wet chemically removing of said layer from the top surface of the substrate (10).

9. The method of Claim 8 wherein an oxalic acid is employed for said wet chemical removal.

## Revendications

1. Procédé pour isoler diélectriquement des segments d'un substrat semiconducteur, comprenant un substrat semiconducteur (10) ayant des rainures (12) définissant ces segments isolés les uns des autres;
caractérisé en ce que:
les surfaces supérieures de ce substrat ainsi que les parois latérales et du fond de ces rainures sont revêtues d'une couche d'oxyde de magnésium (14);

ces rainures sont remplies de diélectrique (16) tandis que simultanément, ce substrat est revêtu de celui-ci; et

ce diélectrique est planarisé jusqu'à niveau exposant la couche d'oxyde de magnésium et dans le prolongement de celle-ci sur la surface supérieure du substrat.

2. Procédé selon la revendication 1, caractérisé en ce que ces segments de substrat constituent la structure d'un circuit intégré.

3. Procédé selon l'une quelconque des revendications 1 ou 2, caractérisé en ce que ce diélectrique (16) est une résine vitreuse.

4. Procédé selon l'une quelconque des revendications 1 à 3, caractérisé en ce que ce traitment de planarisation comprend le revêtement de ce diélectrique (16) avec une couche photosensible en couverture (20) et l'attaque par ions réactifs de cette couche photosensible et de cette résine vitreuse jusqu'à ce que la couche d'oxyde de magnésium (14) soit exposée sur cette surface supérieure de ce substrat (10).

5. Procédé selon l'une quelconque des revendications 1 à 4, caractérisé en ce qu'il comprend de plus l'étape d'élimination de cette couche d'oxyde de magnésium de cette surface supérieure du substrat.

6. Procédé selon l'une quelconque des revendications 1 à 5, caractérisé en ce que l'étape impliquant simultanément le remplissage de ces rainures te le revêtement de ce substrat, comprend la dilution de ce diélectrique et l'application par centrifugation de ce diélectrique dilué sur ce substrat.

7. Procédé selon la revendication 6, caractérisé en ce qu'il comprend de plus l'étape de durcissement de ce diélectrique par chauffage à une température égale ou supérieure à 400°C.

8. Procédé selon la revendication 5, caractérisé en ce que cette étape d'élimination de cette couche d'oxyde de magnésium (14) comprend l'élimination chimique par voie humide de cette couche de la surface supérieure du substrat (10).

9. Procédé selon la revendication 8, caractérisé en ce qu'un acide oxalique est utilisé pour cette élimination chimique par voie humide.

**Patentansprüche**

1. Verfahren zur dielektrischen Isolierung von Segmenten eines Halbleitersubstrats, bestehend aus:

einem Halbleitersubstrat (10) mit Gräben (12), die die besagten voneinander isolierten Segmente definieren;

gekennzeichnet dadurch, daß

die Oberflächen des besagten Substrats mit einer Magnesiumoxidschicht (14) beschichtet werden, einschließlich der seitlichen und unteren Begrenzungen der besagten Gräben (12);

beim Füllen besagter Gräben gleichzeitig das besagte Substrat mit einem Dielektrikum (16) beschichtet wird; und

das besagte Dielektrikum so auf ein Niveau eingeebnet wird, daß die Magnesiumoxidschicht auf der Substratoberfläche freigelegt ist und sich das Dielektrikum mit der Magnesiumoxidschicht in einer Ebene erstrecken.

2. Verfahren nach Anspruch 1, wobei die besagten Substratsegmente eine integrierte Schaltungsstruktur beinhalten.

3. Verfahren nach Anspruch 1 oder 2, wobei das besagte Dielektrikum (16) ein Harzglas ist.

4. Verfahren nach einem der vorigen Ansprüche, wobei die besagte Einebnung eine Beschichtung des besagten Dielektrikums (16) mit einer überdeckenden Resist-Schicht (20) beinhaltet, und mit reaktiver Ionenätzung des besagten Resist und des besagten Harzglas bis die besagte Magnesiumoxidschicht (14) auf der besagten Oberfläche des besagten Substrats (10) freigelegt ist.

5. Verfahren nach einem der vorigen Ansprüche mit dem weiteren Schritt der Entfernung der besagten Magnesiumoxidschicht von der besagten Oberfläche des Substrats.

6. Verfahren nach einem der vorigen Ansprüche, wobei der Schritt des gleichzeitigen Füllens besagter Gräben und Beschichtens des besagten Substrats die Verdünnung des besagten Dielektrikums und Aufspinnens des besagten verdünnten Dielektrikums auf das besagte Substrat beinhaltet.

**7.** Verfahren nach Anspruch 6 mit dem weiteren Schritt des Aushärtens des besagten Dielektrikums durch Erhitzen auf eine Temperatur von 400°C oder darüber.

**8.** Verfahren nach Anspruch 5, wobei der Schritt zur Entfernung der besagten Magnesiumoxidschicht (14) das naßchemische Entfernen der besagten Schicht von der Oberfläche des Substrats (10) beinhaltet.

**9.** Verfahren nach Anspruch 8, wobei eine Oxalsäure für die besagte naßchemische Entfernung verwendet wird.

FIG.1

FIG.2

FIG.3

FIG.4

FIG.5